(19) Europäisches Patentamt
European Patent Office
Office européen des brevets

(11) Veröffentlichungsnummer: **0 303 967**
**A2**

# (12) EUROPÄISCHE PATENTANMELDUNG

(21) Anmeldenummer: **88113041.3**

(51) Int. Cl.4: **G03F 7/02**

(22) Anmeldetag: **11.08.88**

(30) Priorität: **20.08.87 US 87379**

(43) Veröffentlichungstag der Anmeldung:
**22.02.89 Patentblatt 89/08**

(84) Benannte Vertragsstaaten:
**AT CH DE FR GB IT LI NL**

(71) Anmelder: **HOECHST CELANESE CORPORATION**
**Route 202-206 North**
**Somerville, N.J. 08876(US)**

(72) Erfinder: **Jain, Sangya**
**891 Ardsley Lane**
**Bridgewater New Jersey 08807(US)**
Erfinder: **Emmi, Salvatore**
**16140 S.W. Deline Court**
**Beaverton Oregon 97007(US)**
Erfinder: **Phillips, Thomas S.**
**62 W. Warwick Avenue**
**W. Warwick Rhode Island 02893(US)**

(74) Vertreter: **Euler, Kurt Emil, Dr. et al**
**HOECHST AG - Werk KALLE Patentabteilung**
**Postfach 3540 Rheingaustrasse 190**
**D-6200 Wiesbaden(DE)**

## (54) Aufzeichnungsmaterial mit einer Kontrastverstärkungsschicht sowie Verfahren zur Herstellung eines Aufzeichnungsmaterials mit einer darauf aufgebrachten Maske.

(57) Es wird ein Aufzeichnungsmaterial beschrieben, das im wesentlichen aus einem Träger, einer darauf aufgebrachten lichtempfindlichen Schicht, enthaltend ein in Wasser unlösliches, in wäßrigem Alkali und in organischen Lösemitteln lösliches, zumindest aber quellbares Bindemittel und ein o-Chinondiazid, sowie aus einer zweiten lichtempfindlichen Schicht besteht, die ein durch Licht entfärbbares Diazoniumsalz und ein in Wasser lösliches, stark saures und filmbildendes Bindemittel enthält und dadurch gekennzeichnet ist, daß es zusätzlich in der zweiten lichtempfindlichen Schicht ein Kupplungsreagenz für das Diazoniumsalz enthält.

Das Aufzeichnungsmaterial ist grundsätzlich positiv arbeitend, kann aber auch nach Zugabe eines Vernetzungsmittels zur lichtempfindlichen Schicht und nach der Vernetzung negativ arbeitend sein.

Das beschriebene Aufzeichnungsmaterial weist einen hohen Entwicklungskontrast auf.

EP 0 303 967 A2

# Aufzeichnungsmaterial mit einer Kontrastverstärkungsschicht sowie Verfahren zur Herstellung eines Aufzeichnungsmaterials mit einer darauf aufgebrachten Maske

Die vorliegende Erfindung betrifft ein Aufzeichnungsmaterial, im wesentlichen bestehend aus einem Träger, einer darauf aufgebrachten ersten lichtempfindlichen Schicht, enthaltend ein in Wasser unlösliches, in wäßrigem Alkali und organischen Lösemitteln aber lösliches, zumindest aber quellbares Bindemittel und ein o-Chinondiazid, sowie einer zweiten lichtempfindlichen Schicht (Kontrastverstärkungsschicht), enthaltend ein durch Licht entfärbbares Diazoniumsalz und ein in Wasser lösliches, stark saures und filmbildendes Polymeres als Bindemittel.

Die Herstellung von positiv-arbeitenden lichtempfindlichen Gemischen ist bekannt und wird zum Beispiel in US-A-3,666,473, US-A-4,115,128 und US-A-4,173,470 beschrieben. Dabei handelt es sich um Mischungen aus alkalilöslichen Phenolformaldehyd-Novolakharzen als Bindemittel in Verbindung mit insbesondere substituierten Naphthochinondiazidverbindungen als lichtempfindliche Substanzen. Die Harze und lichtempfindlichen Substanzen sind in einem organischen Lösemittel oder Lösemittelgemisch gelöst und als dünne Schicht bzw. Beschichtung auf einen für den vorgesehenen Verwendungszweck geeigneten Schichtträger aufgebracht.

Die Novolakharzkomponente dieser lichtempfindlichen Gemische ist in wäßrig-alkalischen Lösungen löslich, jedoch nicht die lichtempfindliche Naphthochinonverbindung. Wenn bestimmte Bereiche des beschichteten Trägers mit aktinischer Strahlung belichtet werden, erfährt die lichtempfindliche Verbindung eine strukturelle Umwandlung, und die belichteten Bereiche der Beschichtung werden löslicher als die unbelichteten. Durch die Ausbildung eines solchen Löslichkeitsunterschieds lösen sich die belichteten Bereiche der lichtempfindlichen Schicht beim Eintauchen des Schichtträgers in eine alkalische Entwicklerlösung, während die unbelichteten Bereiche weitgehend unbeeinträchtigt bleiben. Die Folge dieses Verhaltens ist, daß auf dem Träger ein positives Reliefbild entsteht.

Für viele technische Anwendungen, insbesondere in der Mikroelektronik, muß ein Photoresist einen hohen Auflösungsgrad aufweisen, wenn er sehr kleine Linien- und Zwischenraumbreiten (in der Größenordnung von 1 µm) wiedergeben soll.

Die Fähigkeit eines Resists zur Wiedergabe sehr kleiner Abmessungen in der Größenordnung von 1 µm und darunter ist bei der Herstellung von LSI-Schaltungen auf Siliziumchips und ähnlichen Komponenten von größter Bedeutung. Die Schaltungsdichte auf einem solchen Chip kann nur durch eine Steigerung des Auflösungsvermögens des lichtempfindlichen Gemisches erhöht werden, sofern es sich um einen photolithographischen Prozeß handelt.

Zur Herstellung von VLSI-Schaltungen sind noch feinere Strukturen und bessere Materialien notwendig. Laut Stand der Technik wird daher vielfach auf der eigentlichen lichtempfindlichen Schicht eine Kontrastverstärkungsschicht aufgebracht.

Andererseits ist bekannt, daß die Brechung des zur Belichtung des Resists verwendeten Lichts, das durch die Maske in den Resist eingestrahlt wird, ein wesentlicher Grund ist für die Minderung der Bildauflösung und des Bildkontrastes, die mit dem jeweiligen Resist erzielt werden könnten. Dieser Umstand gewinnt um so mehr an Bedeutung, je kleiner die zu druckenden Schaltelemente werden.

Aus der EP-A-0 110 165 geht hervor, daß Bildauflösung und -kontrast durch Aufschleudern einer Schicht aus einem kontraststeigernden Mittel auf eine wärmebehandelte Resistschicht wesentlich verbessert werden können. In dem kontraststeigernden Mittel ist ein durch Licht bleichbarer Farbstoff enthalten, der innerhalb des gleichen Wellenlängenbereichs zersetzt wird, mit dem auch die Belichtung der darunterliegenden Resistschicht vorgenommen wird. Durch die Kontrastverstärkungsschicht soll die Auflösung des Bildes verbessert werden, wodurch gleichzeitig der Kontrast in der darunterliegenden Resistschicht erhöht werden soll: Denn das kontraststeigernde Mittel enthält einen das Licht bleichbaren Farbstoff, der das zur Belichtung der Resistschicht verwendete Licht absorbiert, so daß nach dem Ausbleichen des kontraststeigernden Mittels die von Licht getroffenen Stellen der Kontrastverstärkungsschicht eine größtmögliche Transparenz aufweisen, um dadurch eine wirkungsvolle bildmäßige Zersetzung der lichtempfindlichen Verbindung in der darunterliegenden Resistschicht durch das Licht zu erreichen. Die Entfärbung des Farbstoffes im kontraststeigernden Mittel sollte gleich schnell wie oder langsamer als die Zersetzung der in der Photoresistschicht enthaltenen lichtempfindlichen Verbindung vonstatten gehen. Die Kontrastverstärkungsschicht sollte eine möglichst große optische Dichte besitzen.

Die Lehre von EP-A-0 110 165 sieht die Verwendung eines Arylnitrons als lichtbleichbaren Farbstoff in Verbindung mit einem polymeren Bindemittel vor, das jedoch nur in umweltschädlichen organischen Lösemitteln löslich ist.

L.F. Halle schlägt in "A Water Soluble Contrast Enhancement Layer" (Wasserlösliche Kontrastverstärkungsschicht), Journal of Vacuum Science

Technology, Bd. B3(1), Jan./Feb. 1985 eine Lösung des Umweltproblems vor. Der Vorschlag sieht die Verwendung einer Kontrastverstärkungsschicht aus Diphenylamin-p-diazoniumsulfat, Polyvinylalkohol, Wasser und Maleinsäure vor.

Die EP-A-0 161 660 sieht den Einsatz von Diazoniumsalzen, harzartigen Bindemitteln, Wasser und einer sauren Komponente, ebenfalls in einer Kontrastverstärkungs schicht vor. Durch die saure Komponente soll die Löslichkeit des Diazoniumsalzes im kontraststeigernden Mittel erleichtert und Kupplungsreaktionen zwischen dem Diazoniumsalz und den phenolischen Schichtbestandteilen verhindert werden.

Zweifellos sind kontraststeigernde Mittel auf Basis wäßriger Systeme umweltfreundlicher und führen auch nicht zur Ausbildung von Vermischungszonen mit dem Resist. Doch wird zur Herstellung dieser bekannten wäßrigen Diazoniumsalzsysteme stets eine saure Komponente benötigt, um die Löslichkeit der sonst nur schwerlöslichen Diazoniumsalze zu erhöhen und Kupplungsreaktionen der Diazoniumsalze zu unterdrücken. Bei der in EP-A-0 116 660 beschriebenen Lösung ist zur Verbesserung der Löslichkeit des Diazoniumsalzes beispielsweise eine nahezu äquimolare Menge p-Toluolsulfonsäure erforderlich.

In der prioritätsälteren, aber nicht vorveröffentlichten US-Anmeldung (Ser.No. 056,032) wird ein Aufzeichnungsmaterial beschrieben, im wesentlichen bestehend aus einem Träger, einer darauf aufgebrachten lichtempfindlichen Schicht, enthaltend ein in Wasser unlösliches, in wäßrigem Alkali und organischen Lösemitteln aber lösliches, zumindest aber quellbares Bindemittel und ein o-Chinondiazid, sowie einer Kontrastverstärkungsschicht, enthaltend ein durch Licht entfärbbares Diazoniumsalz und ein in Wasser lösliches, stark saures und filmbildendes Polymeres als Bindemittel.

Ausgehend von diesem Stand der Technik bestand die Aufgabe, ein Aufzeichnungsmaterial bereitzustellen, dessen Kontrastverstärkungsschicht einen weit verbesserten Entwicklungskontrast liefert, eine gute Bildauflösung zeigt, sowie erhöhte Löslichkeit im Entwickler aufweist und zugleich auf keine umweltschädlichen organischen Lösemittel mehr angewiesen ist.

Die Erfindung wird gelöst durch ein Aufzeichnungsmaterial, in wesentlichen bestehend aus einem Träger, einer darauf aufgebrachten ersten lichtempfindlichen Schicht, enthaltend ein in Wasser unlösliches, in wäßrigen Alkalien und in organischen Lösemitteln lösliches, zumindest aber quellbares Bindemittel und ein o-Chinondiazid, sowie eine zweite lichtempfindliche Schicht (Kontrastverstärkungsschicht), enthaltend ein durch Licht entfärbbares Diazoniumsalz und ein in Wasser lösliches, stark saures und filmbildendes Bindemittel, dadurch gekennzeichnet, daß diese Schicht ein Kupplungsreagenz für das Diazoniumsalz enthält.

Erfindungsgemäß können der Kontrastverstärkungsschicht auch die in der EP-A-0 161 660 beschriebenen sauren Zusatzstoffen zugesetzt werden, bevorzugt kann jedoch auf diese verzichtet werden.

Unter Bildauflösung des Resists versteht man die Fähigkeit eines Resistsystems zur Wiedergabe der kleinsten, im gleichen Abstand voneinander angeordneten Linienpaare und der zugehörigen Zwischenräume einer für die Belichtung verwendeten Maske, die einen hohen Grad an Flankensteilheit in den ausentwickelten belichteten Zwischenräumen eines durch diese Maske belichteten Photoresists gewährleistet.

Unter Entwicklungskontrast ist die Neigung einer linearen Kurve zu verstehen, die erhalten wird, indem man die nach der Belichtung mit unterschiedlicher Intensität und anschließender Entwicklung erhaltenen Schichtdicken gegen den Logarithmus der jeweiligen Belichtungsintensität anträgt.

Erfindungsgemäß enthält die auf den Träger aufgebrachte lichtempfindliche Schicht das lichtempfindliche o-Chinondiazid in ausreichender Menge, um eine Sensibilisierung der Schicht durch aktinisches Licht zu bewirken, so daß durch bildmäßiges Belichten und anschließendes Entwickeln eine bildmäßige Differenzierung erhalten wird. Die gesamte Schicht enthält mindestens ein in Wasser unlösliches, in wäßrigem Alkali lösliches harzartiges Bindemittel aus der Gruppe der Novolake, Polyvinylphenole und Polyvinylphenolcopolymeren, das dem o-Chinondiazid in ausreichender Menge zugesetzt wird, um das Entstehen eines gleichmäßigen Filmes zu bewirken.

Die zweite lichtempfindliche Schicht (Kontrastverstärkungsschicht) enthält ein wasserlösliches, durch Licht entfärbbares Diazoniumsalz und ein Kupplungsreagenz, jeweils in ausreichender Menge, um bei Belichtung mit aktinischer Strahlung eine bildmäßige Differenzierung durch Ausbleichen zu erzielen, sowie ferner ein stark saures, wasserlösliches, filmbildendes, polymeres und harzartiges Bindemittel, das in ausreichender Menge zugesetzt wird, um das Entstehen eines gleichmäßigen Filmes zu bewirken.

Erfindungsgemäß wird ferner ein Verfahren zur Herstellung eines bebilderten Aufzeichnungsmaterials vorgeschlagen, bei dem ein Schichtträger mit einer ersten lichtempfindlichen Schicht beschichtet wird, enthaltend ein lichtempfindliches o-Chinondiazid, das in ausreichender Menge eingesetzt wird, um eine Sensibilisierung der Schicht für aktinisches Licht zu bewirken, so daß durch bildmäßiges Belichten und anschließendes Entwikkeln eine bildmäßige Differenzierung erhalten wird, und mindestens ein harzartigen Bindemittel aus der Gruppe der Novolake, Polyvinylphenole und Polyvinylphenolcopolymere, das dem o-Chinondiazid in ausreichender Menge zugesetzt wird, um das Entstehen eines gleichmäßigen Filmes zu bewirken; auf diese erste lichtempfindliche Schicht eine zweite lichtempfindliche Schicht aufgetragen wird, umfassend ein wasserlösliches, durch Licht entfärbbares Diazoniumsalz und ein Kupplungsreagenz für das Diazoniumsalz, jeweils in ausreichender Menge, um bei Belichtung mit aktinischer Strahlung eine bildmäßige Differenzierung durch Ausbleichen zu erzielen und um unter Einwirkung von genügend gasförmigem Ammoniak in den nicht belichteten Bereichen einen UV-Licht absorbierenden Azofarbstoff zu bilden sowie im Gemisch mit dem Diazoniumsalz ein stark saures, wasserlösliches, filmbildendes, polymeres und harzartiges Bindemittel, das in ausreichender Menge zugesetzt wird, um das Entstehen eines gleichmäßigen Filmes zu bewirken; das so hergestellte Material mittels aktinischer Strahlung ausreichend belichtet wird, um ein Ausbleichen der belichteten Stellen der zweiten lichtempfindlichen Schicht zu bewirken, wobei diese entfärbten Stellen für die aktinische Strahlung durchlässig werden, und die Schicht einer genügenden Menge an gasförmigem Ammoniak auszusetzen, um in den nicht belichteten Bereichen einen UV absorbierenden Azofarbstoff zu bilden, die so behandelte Schicht einer ganzflächigen Belichtung auszusetzen, deren Wellenlängenbereich dem Absorptionsbereich des gebildeten Azofarbstoffes entspricht und daher die zweite lichtempfindliche Schicht als Maske für die Belichtung der ersten lichtempfindlichen Schicht wirkt; und anschließend die gesamte zweite lichtempfindliche Schicht entfernt wird und die erste lichtempfindliche Schicht ausentwickelt wird.

Wie bereits vorstehend erwähnt wurde, besteht das erfindungsgemäße Aufzeichnungsmaterial aus einem Schichtträger, der mit einer ersten und einer zweiten lichtempfindlichen Schicht beschichtet ist. Als Schichtträger kann dabei jedes für die Aufnahme der ersten lichtempfindlichen Schicht geeignete Material eingesetzt werden. Bevorzugt besteht der Schichtträger jedoch aus Silicium, Aluminium, polymeren Harzen, Siliciumdioxid, dotiertem Siliciumdioxid, Siliciumnitrid, Tantal, Kupfer, polykristallines Silicium (polysilicon), Keramik, Aluminium/Kupfer-Mischungen, Galliumarsenid oder anderen Verbindungen der Elementgruppe III/V, bzw. aus Mischungen mehrerer der aufgezählten Komponenten.

Auf den Schichtträger wird gegebenenfalls eine haftvermittelnde Schicht aufgebracht, beispielsweise aus einem Hexaalkyldisilazan enthaltenden Gemisch.

Der Schichtträger wird mit einem lichtempfindlichen Gemisch beschichtet. Bevorzugt enthält dieses Gemisch einen bekannten Sensibilisator auf der Basis von o-Chinondiaziden sowie als Bindemittel ein Novolak- oder Polyvinylphenolharz, insbesondere Kresol-Formaldehyd-Novolakharze. Diese Bestandteile werden mit einem geeigneten Lösemittel versetzt; anschließend wird die Lösung auf den Schichtträger aufgetragen und getrocknet, bis sie nicht mehr klebrig ist.

Novolakharze, die für die Herstellung von lichtempfindlichen Gemischen verwendet werden können, sind bekannt. Ein Verfahren zur Herstellung dieser Novolake ist in "Chemistry and Application of Phenolic Resins" (Chemie und Anwendung von Phenolharzen), von A. Knop und W.Scheib, Springer Verlag, New York, 1979, Kapitel 4, beschrieben.

Dem Fachmann ist auch die Verwendung von o-Chinondiaziden bekannt. Diese werden in "Light Sensitive Systems" von J. Kosar, John Wiley & Sons, New York, 1965, Kapitel 7.4, beschrieben. Die lichtempfindlichen Verbindungen, die Bestandteil der UV-empfindlichen Resistgemische der vorliegenden Erfindung sind, gehören zur Gruppe der substituierten lichtempfindlichen Naphthochinondiazide, wie sie üblicherweise in positiv-arbeitenden Photoresists verwendet werden. Solche Verbindungen sind zum Beispiel aus US-A2,797,213, US-A-3,106,465, US-A-3,148,983, US-A3,130,047, US-A-3,201,329, US-A-3,785,825 und US-A-3,802,855 bekannt. Geeignete lichtempfindliche Verbindungen sind zum Beispiel mit phenolischen Verbindungen, wie Hydroxybenzophenonen, insbesondere Trihydroxybenzophenonen oder Hydroxyalkylphenonen, kondensiertes 1,2-Naphthochinon-2-diazid-5-sulfonylchlorid und/oder 1,2-Naphthochinon-2-diazid-4-sulfonylchlorid.

Besonders bevorzugt sind Kondensationsprodukte aus 1,2-Naphthochinon-2-diazid-5-sulfonylchloriden und Trihydroxybenzophenonen, insbesondere 2,3,4-Trihydroxybenzophenon.

In bevorzugter Ausführungsform liegt der Gehalt an festen Bestandteilen des lichtempfindlichen Gemischs, d.h. an Bindemittel, vorzugsweise bei etwa 15 bis 99 Gewichtsprozent und an o-Chinondiaziden bei etwa 1 bis 85 Gewichtsprozent. Insbesondere ist das Bindemittel in einem Anteil von etwa 50 bis 90 Gewichtsprozent, und ganz besonders bevorzugt von etwa 65 bis 85 Gewichtsprozent, bezogen auf das Gewicht der festen Bestand teile des lichtempfindlichen Gemischs, in dem Gemisch enthalten. Der Anteil an o-Chinondiazid liegt insbesondere bei etwa 10 bis 50 Gewichtsprozent und ganz besonders bevorzugt bei etwa 15 bis 35 Gewichtsprozent, bezogen auf das Gewicht der festen Bestandteile des lichtempfindlichen Gemischs.

Die Auswahl des Lösemittels richtet sich nach dem jeweiligen Beschichtungsverfahren, der gewünschten Schichtdicke und den Trocknungsbedingungen. Für die erfindungsgemäßen Gemische eignen sich als Lösemittel beispielsweise Ether (z. B. Tetrahydrofuran), Alkohol (z. B. n-Propanol), Alkoholether (z. B. Ethylenglykolmonoethylether), Ester (z. B. Butylacetat), aromatische oder aliphatische Kohlenwasserstoffe (z. B. Xylol) oder Gemische aus den genannten Lösemitteln. Prinzipiell sind alle Lösemittel geeignet, die nicht irreversibel mit den Schichtbestandteilen reagieren. Bevorzugt werden teilveretherte Glykole, insbesondere Ethylen- oder Propylenglykolmonoethylether oder deren Ester verwendet.

Als bevorzugtes Lösemittel sei hier Propylenglykolmonomethyletheracetat genannt. Auch Xylol, Butylacetat und Ethylenglykolmonoethyletheracetat sind geeignete Lösemittel.

Der Lösung aus Bindemittel, lichtempfindlicher Verbindung und Acetat können vor dem Aufbringen auf einen Schichtträger noch Zusätze, wie z. B. Farbmittel, Farbstoffe, Verlaufmittel, Weichmacher, Haftvermittler, Entwicklungsbeschleuniger, weitere Lösemittel und Tenside, z. B. nicht-ionische Tenside, zugegeben werden.

Farbstoffe, die als Zusätze für die erfindungsgemäßen lichtempfindlichen Gemische verwendet werden können, sind zum Beispiel Methylviolett 2B (C.I. 42 535), Kristallviolett (C.I. 42 555), Malachitgrün (C.I. 42 000), Viktoriablau B (C.I. 44 405) und Neutralrot (C.I. 50 040). Diese Farbstoffe werden in einer Menge von 1 bis 10 Gewichtsprozent, bezogen auf das Gesamtgewicht von Bindemittel und lichtempfindlicher Verbindung, zugesetzt. Die Farbstoffzusätze verringern die Rückstreuung von Licht vom Schichtträger und tragen so zu einer verbesserten Bildauflösung bei. Verlaufmittel können in einer Menge bis zu 5 Gewichtsprozent, bezogen auf das Gesamtgewicht von Bindemittel und lichtempfindlicher Verbindung, eingesetzt werden.

Geeignete Weichmacher sind zum Beispiel Phosphorsäuretri($\beta$-chlorethyl)-ester, Stearinsäure, Dicampher, Polypropylen, Acetalharze, Phenoxyharze und Alkydharze, die in Anteilen von 1 bis 10 Gewichtsprozent, bezogen auf das Gesamtgewicht von Bindemittel und lichtempfindlicher Verbindung, zugesetzt werden können. Die Weichmacherzusätze verbessern die Beschichtungseigenschaften des Gemischs und ermöglichen das Auftragen in einer glatten und gleichmäßig dicken Schicht auf den Schichtträger.

Geeignete Haftvermittler sind zum Beispiel $\beta$-(3,4-Ep oxycyclohexyl)-ethyltrimethoxysilan, p-Methyldisilanmethylmethacrylat, Vinyltrichlorsilan und $\gamma$-Aminopropyltriethoxysilan in einem Anteil bis zu 4 Gewichtsprozent, bezogen auf das Gesamtgewicht von Bindemittel und lichtempfindlicher Verbindung.

Als Entwicklungsbeschleuniger können beispielsweise Pikrinsäure, Nicotinsäure oder Nitrozimtsäure in einem Anteil bis zu 20 Gewichtsprozent, bezogen auf das Gesamtgewicht von Bindemittel und lichtempfindlicher Verbindung, zugegeben werden. Diese Beschleuniger führen dazu, daß die Löslichkeit der Photoresistschicht sowohl in den belichteten als auch in den unbelichteten Bereichen zunimmt, und sie werden deshalb bei solchen Anwendungen eingesetzt, bei denen es in erster Linie auf die Entwicklungsgeschwindigkeit ankommt, auch wenn dabei evtl. ein gewisser Grad an Kontrast geopfert wird; denn während die belichteten Bereiche der lichtempfindlichen Schicht durch den Zusatz von Beschleunigern vom Entwickler schneller gelöst werden, bewirken die Entwicklungsbeschleuniger gleichzeitig auch einen größeren Verlust an lichtempfindlicher Schicht aus den unbelichteten Bereichen.

Als nicht-ionische Tenside können zum Beispiel Nonylphenoxy-poly(ethylenoxy)-ethanol, Octylphenoxy(ethylenoxy)-ethanol, und Dinonylphenoxy-poly(ethylenoxy) ethanol in einem Anteil bis zu 10 Gewichtsprozent, bezogen auf das Gesamtgewicht von Bindemittel und lichtempfindlicher Verbindung, verwendet werden.

Die fertige Photoresistlösung kann nach einem der in der Photoresisttechnik üblichen Verfahren, wie Tauchen, Sprühen und Aufschleudern, auf einen Träger aufgebracht werden. Für das Aufschleudern kann zum Beispiel der Prozentanteil an Feststoffen in der Resistlösung so eingestellt werden, daß sich in Abhängigkeit von der im Einzelfall verwendeten Aufschleudervorrichtung und der für den Aufschleudervorgang angesetzten Zeitspanne eine Beschichtung in der gewünschten Dicke ergibt.

Im Anschluß an das Aufbringen der Resistlösung auf den Schichtträger erfolgt eine Wärmebehandlung bei etwa 80 bis 105° C, bis das Lösemittel praktisch vollständig verdampft ist und eine dünne lichtempfindliche Schicht von nur etwa 1 $\mu$m Dicke auf dem Schichtträger erhalten wird.

Auf die so erhaltene Schicht wird als zweite lichtempfindliche Schicht die Kontrastverstärkungsschicht aufgetragen, eine Schicht aus einem kontraststeigernden Material, enthaltend ein wasserlösliches, durch Licht entfärbbares Diazoniumsalz, ein Kupplungsreagenz für das Diazoniumsalz und ein polymeres Bindemittel, das eine starke Säure darstellt. Die einzelnen Komponenten werden in Wasser gemischt. Zusätzlich kann, wenn es gewünscht wird, Säure addiert werden, um vorzeitige und unerwünschte Kupplungsreaktionen zu unterbinden.

Erfindungsgemäß sind praktisch alle aus dem Stand der Technik bekannten wasserlöslichen Diazoniumsalze als durch Licht entfärbbare Diazoniumsalze in der zweiten lichtempfindlichen Schicht geeignet. Dazu gehören beispielsweise die Diazoniumsalze, die von J. Kosar in "Light Sensitive Systems" (Lichtempfindliche Systeme), 1965, J. Wiley Sons Inc., New York, S. 194, und von M.S. Dinaburg in "Photosensitive Diazo Compounds and Their Uses" (Lichtempfindliche Diazoverbindungen und ihre Anwendung), 1964, The Focal Press, beschrieben sind. Als Diazoniumsalze sind bevorzugt p-Phenylendiamindiazoniumchlorid.

Der Anteil an Diazoniumsalz beträgt normalerweise 10 bis 50 Gewichtsprozent, bevorzugt 20 bis 40 Gewichtsprozent, jeweils bezogen auf die festen Schichtbestandteile. Der Anteil an polymeren Bindemittel, das eine starke Säure darstellt, beträgt gewöhnlich 50 bis 90 Gewichtsprozent, bevorzugt 60 bis 80 Gewichtsprozent, jeweils bezogen auf die festen Schichtbestandteile.

Als Beispiele für stark saure Polymergruppen seien $-SO_3H$- und $-OSO_3H$-Gruppen genannt. Entsprechende Polymere sind beispielsweise Polystyrolsulfonsäure, Polyethylensulfonsäure, Polyvinylsulfonsäure und Polyvinylphenylsulfonsäure, von denen Polystyrolsulfonsäure bevorzugt eingesetzt wird. Es ist auch möglich, Copolymere von Vinylsulfonsäure oder Styrolsulfonsäure herzustellen und zu verwenden.

Das stark saure Polymere in der zweiten lichtempfindlichen Schicht wird in einer Menge von 50 bis 90Gew.-%, insbesondere von 65 bis 75 Gew.-%, bezogen auf die festen Bestandteile der zweiten lichtempfindlichen Schicht, zugegeben.

Als Kupplungsreagenzien, die in der zweiten lichtempfindlichen Schicht enthalten sind, kommen Verbindungen der allgemeinen Formel I in Frage.

$$R_1 - C(=O) - CH_2 - R_2 \qquad (I)$$

worin

$R_1$ Alkyl, Aryl, O-Alkyl, O-Aryl und $-NR_3R_4$,

$R_2$ CN, $-C(=O)-$Alkyl, $-C(=O)-$Aryl, $-C(=O)-OH$, $-C(=O)-O-$Alkyl, $-C(=O)-O-$Aryl, $-C(=O)-NR_3R_4$ und $-C(=NH)-OC_2H_5$ bedeuten, bei denen

$R_3$, $R_4$ gleich oder verschieden sein können und für H, Alkyl, Aryl, Pyridino, Alkyl-COOH, Aryl-COOH, Alkyl-$SO_3H$ und Aryl-$SO_3H$ stehen.

Ein bevorzugtes Kupplungsreagenz ist die Acetoacetyl-p-kresidinsulfonsäure oder ihre Salze.

Das Kupplungsreagenz wird in Mengen von 1 bis 40 Gew.-%, oder bevorzugt von 5 bis 25 Gew.-% und besonders bevorzugt von 10 bis 20 Gew.-%, bezogen auf die festen Bestandteile der zweiten lichtempfindlichen Schicht, eingesetzt.

Die Eigenschaften der Kontrastverstärkungsschicht können durch entsprechende Zusätze, wie Tenside, Entschäumungsmittel usw. verbessert werden.

Die zweite lichtempfindliche Schicht kann in einer Dicke von etwa 1,0 µm aufgeschleudert werden, um besonders effektiv für die erste lichtempfindliche Schicht als Maske wirken zu können. Sie kann zur Verdampfung des Wassers luftgetrocknet oder wärmebehandelt werden, ohne daß es zu einem Abbau der festen Bestandteile kommt.

Bei der bildmäßgen Belichtung des so hergestellten Doppelschichtmaterials dringt das Licht durch die zweite lichtempfindliche Schicht in die erste lichtempfindliche Schicht ein. Die zweite lichtempfindliche Schicht wird anschließend durch Kontakt mit Alkali, insbesondere mit gasförmigem Ammoniak, behandelt, um die Säure zu neutralisieren und die Kupplungsreaktion zwischen Diazoniumsalz und Kupplungsreagenz im basischen Medium zu ermöglichen. Der dabei entstehende Farbstoff ist tief gefärbt und erlaubt es deswegen, das entstehende Bild auch schon vor dessen Entwicklung als solches wahrzunehmen. Die bildmäßige Differenzierung der zweiten lichtempfindlichen Schicht erlaubt zugleich auch, eine ganzflächige Belichtung der darunter liegenden ersten lichtempfindlichen Schicht durch die als Maske dienenden ersten lichtempfindlichen Schicht durchzuführen. Die Maske wird nach der Belichtung der ersten lichtempfindlichen Schicht durch Behandlung mit Wasser entfernt; die Entfernung kann aber auch während des nachfolgenden Entwicklungsschrittes der ersten lichtempfindlichen Schicht erfolgen. Die darunterliegende erste lichtempfindliche Schicht wird mit einem geeigneten wäßrig alkalischen Entwickler entwickelt, beispielsweise mit einem bekannten wäßrig-alkalischen Entwickler, wie AZ Developer (Hersteller AZ Photoresist Products Group der Hoechst Celanese Corporation, Somerville, New Jersey, USA).

Üblicherweise wird mit aktinischer Strahlung bestrahlt, insbesondere mit UV-Strahlung. Die Kontrastverstärkungsschicht kann auch mit Licht nur einer Wellenlänge belichtet werden.

In der Tat entfärbt sich das kontraststeigernde Mittel beim bildmäßigen Belichten und wird an den belichteten Stellen farblos. In den nicht belichteten Stellen muß der sich nach der Behandlung, insbesondere mit Ammoniak, bildende Azofarbstoff die Wellenlänge des Lichtes, mit der die nachfolgende Belichtung der darunterliegenden ersten lichtempfindlichen Schicht vorgenommen wird, absorbieren. Diese Absorption erfolgt im UV-Bereich, insbesondere im Bereich von 313 bis 450 nm, ganz besonders bevorzugt ist die Absorption bei 436 nm. Bei der Belichtung der ersten lichtempfindlichen Schicht dringt die aktinische Strahlung durch die transparen ten, entfärbten Stellen der zweiten lichtempfindlichen Schicht hindurch, während der in den nicht belichteten Stellen gebildete Azofarbstoff

ein Belichten des darunterliegenden Bereiches der ersten lichtempfindlichen Schicht verhindert. Deswegen ist eine bildmäßige Belichtung der ersten lichtempfindlichen Schicht möglich. Vorzugsweise besitzen die unbelichteten Stellen der zweiten lichtempfindlichen Schicht eine Durchlässigkeit für diese Wellenlänge des Lichtes, mit denen belichtet wird, von weniger als 10 %, besonders bevorzugt von weniger als 1%.

Lichtempfindliche Verbindungen auf der Basis von o-Chinondiaziden ergeben zwar im allgemeinen positiv-arbeitende Systeme, doch ist die Erfindung nicht auf derartige Systeme beschränkt, obwohl sie diese insbesondere betrifft. Die Erfindung beinhaltet auch die sogenannten Bildumkehrverfahren, bei denen durch entsprechende Zusätze zu den lichtempfindlichen Gemischen und/oder durch zusätzliche Verfahrensschritte negative Bilder in den o-Chinondiazidschichten erhalten werden können. Dies ist zum Beispiel möglich, indem man der lichtempfindlichen Schicht ein Vernetzungsmittel, wie ein Dimethylol-p-kresol, zusetzt.

Anhand der folgenden Beispiele werden Herstellung und Verwendung der erfindungsgemäßen Gemische näher erläutert, ohne daß jedoch eine Beschränkung auf diese beispielhaften Ausführungen stattfinden soll.

Beispiel 1 (Vergleichsbeispiel)

Aus folgenden Bestandteilen wird ein positiv arbeitendes lichtempfindliches Gemisch hergestellt:

24,4 Gew.-% eines Kresol-Novolaks mit einem Erweichungsbereich von 105 bis 120 °C,
7,5 Gew.-% eines Kondensationsproduktes aus 2,3,4-Trihydroxybenzophenon und 1,2-Naphthochinon-2-diazid-5-sulfonylchlorid als lichtempfindliche Verbindung und
68,1 Gew.-% Propylenglykolmethyletheracetat.

Die Resistlösung wird auf einen Siliciumwafer bei 4.000 U/min aufgechleudert und für 30 Minuten bei 90 °C in einem Umlufttrockenschrank getrocknet, so daß eine 1,9 µm dicke Schicht erhalten wird. Der mit diesem Resist erzielbare Bildkontrast wird durch Belichten der Schicht durch eine Glasmaske abgestufter, bekannter optischer Dichte bestimmt. Die Belichtung wird bei einer Wellenlänge von 436 nm vorgenommen, die aus dem Licht einer Breitbandbelichtungsvorrichtung ausgefiltert wurde.

Die Entwicklung erfolgt innerhalb von 60 sec in einem Entwickler folgender Zusammensetzung:

5,3 g Natriumsilikat x 9 $H_2O$,
3,4 g Trinatriumphosphat x 12 $H_2O$,
0,3 g Natriumdihydrogenphosphat und

soviel vollentsalztes Wasser, daß eine Entwicklerkonzentration von 0,23 n erzielt wird.

Anschließend wird die Schichtdicke gemessen, die nach der Belichtung mit einer bestimmten Belichtungsintensität nach dem Entwickeln vorhanden ist. Die Neigung der Kurve, die durch Auftragen der übriggebliebenen Schichtdicke gegen den Logarithmus der Belichtungsintensität erhalten wird, gibt den Entwicklungskontrast des Resists an. Der in dieser Weise ermittelte Entwicklungskontrast bei einer Belichtungsenergie von 93mJ/cm² beträgt 6,7.

Beispiel 2

Aus den folgenden Bestandteilen wird die Beschichtungslösung für die zweite lichtempfindliche Schicht hergestellt:

5,4 g Polystyrolsulfonsäure (15%ige Lösung in Wasser),
3,2 g Wasser,
1,1 g 2,5-Diethoxy-4-morpholinobenzdiazoniumchlorid-1,2-Zinkchlorid,
0,88 g Ammonium-Acetoacetyl-p-kresidinsulfonat.

Auf einen entsprechend Beispiel 1 hergestellten beschichteten Siliciumwafer wird die oben beschriebene Beschichtungslösung bei 2.000 U/min aufgeschleudert und bei 90 °C für 30 Minuten in einem Umluftofen getrocknet. Die Dicke der entstehenden zweiten lichtempfind lichen Schicht beträgt 1,0 µm. Das Aufzeichnungsmaterial, enthaltend die beiden lichtempfindlichen Schichten, wird durch eine Glasmaske bildmäßig belichtet. Die Belichtungsvorrichtung erfolgt mit einem Breitbandbelichtungsgerät vom Typ Perkin Elmer Microalign 220.

Der bildmäßig belichtete Wafer wird anschließend für 60s über eine Lösung, bestehend aus Ammoniumhydroxid, gehalten. Die nicht belichteten Bereiche werden dadurch rötlich gefärbt, wodurch sich ein starker Bildkontrast ausbildet. Anschließend wird das zweischichtige System einer Belichtung mit einer Belichtungsenergie von 100mJ/cm² bei 436 nm ausgesetzt. Die als Maske wirkende zweite lichtempfindliche Schicht wird mit entsalztem Wasser entfernt. Die bildmäßig belichtete darunterliegende erste lichtempfindliche Schicht wird anschließend mit dem im Beispiel 1 angegebenen Entwickler 60 s lang entwickelt. Entsprechend Beispiel 1 wird der Entwicklungskontrast zu 12,1 ermittelt, bei einer Belichtungsenergie von 129 mJ/cm².

**Ansprüche**

1. Aufzeichnungsmaterial, im wesentlichen bestehend aus einem Träger, einer darauf aufgebrachten ersten lichtempfindlichen Schicht enthaltend ein in Wasser unlösliches, in wäßrigem Alkali und in organischen Lösungsmitteln lösliches, zumindest aber quellbares Bindemittel und ein o-Chinondiazid, sowie eine zweite lichtempfindliche Schicht, enthaltend ein durch Licht entfärbbares Diazoniumsalz und ein in Wasser lösliches, stark saures und filmbildendes Bindemittel, dadurch gekennzeichnet, daß diese Schicht ein Kupplungsreagenz für das Diazoniumsalz enthält.

2. Aufzeichnungsmaterial nach Anspruch 1, dadurch gekennzeichnet, daß die lichtempfindliche Schicht positiv arbeitend ist.

3. Aufzeichnungsmaterial nach Anspruch 1, dadurch gekennzeichnet, daß die lichtempfindliche Schicht zusätzlich ein Vernetzungsmittel, insbesondere Dimethylol-p-Kresol, enthält und deswegen negativ arbeitend ist.

4. Aufzeichnungsmaterial nach einem oder mehreren der Ansprüche 1 bis 3, dadurch gekennzeichnet, daß als o-Chinondiazid ein Kondensationsprodukt aus 1,2-Naphthochinon-2-diazid-5- und/oder -4-sulfonylchlorid mit einem Hydroxybenzophenon oder einem Hydroxyalkylphenon eingesetzt wird.

5. Aufzeichnungsmaterial nach Anspruch 4, dadurch gekennzeichnet, daß als o-Chinondiazid das Kondensationsprodukt aus 1,2-Naphthochinon-2-diazid-5-sulfonylchlorid und 2,3,4-Trihydroxybenzophenon verwendet wird.

6. Aufzeichnungsmaterial nach den Ansprüchen 1 und 2, dadurch gekennzeichnet, daß das Polymere $-SO_3H$ und/oder $-OSO_3H$-Gruppen enthält.

7. Aufzeichnungsmaterial nach einem oder mehreren der Ansprüche 1 bis 6, dadurch gekennzeichnet, daß als Kupplungsreagenz in der zweiten lichtempfindlichen Schicht Verbindungen der allgemeinen Formel I in Frage kommen:

$$R_1 - \underset{\underset{\displaystyle O}{\|}}{C} - CH_2 - R_2 \qquad \text{(I)}$$

worin

$R_1$ Alkyl, Aryl, O-Alkyl, O-Aryl und $-NR_3R_4$,

$R_2$ CN, $-\overset{\overset{\displaystyle O}{\|}}{C}$-Alkyl, $-\overset{\overset{\displaystyle O}{\|}}{C}$-Aryl, $-\overset{\overset{\displaystyle O}{\|}}{C}$-OH, $-\overset{\overset{\displaystyle O}{\|}}{C}$-O-Alkyl, $-\overset{\overset{\displaystyle O}{\|}}{C}$-O-Aryl, $-\overset{\overset{\displaystyle O}{\|}}{C}-NR_3R_4$ und $-\overset{\overset{\displaystyle NH}{\|}}{C}-OC_2H_5$

bedeuten, bei denen

$R_3$, $R_4$ gleich oder verschieden sein können und für H, Alkyl, Aryl, Pyridino, Alkyl-COOH, Aryl-COOH, Alkyl-$SO_3H$ und Aryl-$SO_3H$ stehen.

8. Aufzeichnungsmaterial nach einem oder mehreren der Ansprüche 1 bis 7, dadurch gekennzeichnet, daß die zweite lichtempfindliche Schicht neben Wasser mehrere Zusätze, wie Tenside und Entschäumungsmittel enthält.

9. Verfahren zur Herstellung eines Aufzeichnungsmaterials mit einer darauf aufgebrachten Maske, dadurch gekennzeichnet, daß das lichtempfindliche Gemisch gemäß den Ansprüchen 1 bis 8 auf einem ggf. mit einem Haftvermittler behandelten Träger aufgebracht wird, die Schicht getrocknet wird bis sie nicht mehr klebrig ist und anschließend die zweite lichtempfindliche Schicht gemäß den Ansprüchen 1 bis 8 aufgetragen wird und diese zur Verdampfung des Wassers luftgetrocknet oder wärmebehandelt wird, daß die zweite lichtempfindliche Schicht bildmäßig belichtet wird und daß in den nicht belichteten Stellen dieser Schicht mit den durch Licht nicht zerstörten o-Chinondiaziden durch Aussetzung der Schicht eines gasförmigen Alkalis, insbesondere gasförmigen Ammoniaks, ein Farbstoff entsteht, so daß sich ein Bildkontrast ergibt, der als Maske bei der anschließenden Belichtung der ersten lichtempfindlichen Schicht dient und daß die erste lichtempfindliche Schicht durch diese Maske ganzflächig belichtet und anschließend das System mit einem wäßrig-alkalischen Entwickler entwickelt wird.

10. Verfahren nach Anspruch 9, dadurch gekennzeichnet, daß der in der zweiten lichtempfindlichen Schicht gebildete Farbstoff ein Azofarbstoff ist, der Licht im UV-Bereich, insbesondere bei 313 bis 430 nm, absorbiert.

11. Verfahren nach den Ansprüchen 9 und 10, dadurch gekennzeichnet, daß die zweite lichtempfindliche Schicht nach Belichtung der ersten lichtempfindlichen Schicht durch Behandeln mit Wasser entfernt wird.

12. Verfahren nach einem oder mehreren der Ansprüche 9 bis 11, dadurch gekennzeichnet, daß die erste lichtempfindliche Schicht ein Vernetzungsmittel enthält, die erste lichtempfindliche Schicht nach der bildmäßigen Belichtung mit aktinischer Strahlung vernetzt ist und nach dem Entwickeln mit wäßrig alkalischem Entwickler ein negatives Bild entsteht.